(19) **Europäisches Patentamt / European Patent Office / Office européen des brevets**

(11) **EP 2 598 455 B1**

(12) # FASCICULE DE BREVET EUROPEEN

(45) Date de publication et mention de la délivrance du brevet:
**10.09.2014 Bulletin 2014/37**

(21) Numéro de dépôt: **11754708.3**

(22) Date de dépôt: **20.07.2011**

(51) Int Cl.:
***C03C 17/34*** *(2006.01)*

(86) Numéro de dépôt international:
**PCT/FR2011/051749**

(87) Numéro de publication internationale:
**WO 2012/022876 (23.02.2012 Gazette 2012/08)**

(54) **VITRAGE**

VERGLASUNG

GLAZING PANEL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.07.2010 FR 1056218**

(43) Date de publication de la demande:
**05.06.2013 Bulletin 2013/23**

(73) Titulaire: **Saint-Gobain Glass France
92400 Courbevoie (FR)**

(72) Inventeurs:
• **DURANDEAU, Anne
F-75009 Paris (FR)**
• **KHARCHENKO, Andriy
F-91120 Palaiseau (FR)**
• **ROY, Sébastien
F-78320 Le Mesnil Saint Denis (FR)**
• **GERARDIN, Hadia
F-75012 Paris (FR)**
• **LORREN, Anne
F-60280 Margny Les Compiegne (FR)**

(74) Mandataire: **Teyssedre, Laurent
Saint-Gobain Recherche
Département Propriété Industrielle
39 Quai Lucien Lefranc
93300 Aubervilliers Cedex (FR)**

(56) Documents cités:
**EP-A1- 1 637 225       EP-A1- 1 816 109
WO-A2-2007/115796   CN-A- 101 054 268
US-A1- 2002 028 361   US-A1- 2003 215 648
US-A1- 2006 029 813**

• **TADATSUGU MINAMI: "Transparent conducting oxidesemiconductors for transparent electrodes", SEMICONDUCTOR SCIENCE AND TECHNOLOGY, IOP PUBLISHING LTD, GB, vol. 20, no. 4, 1 janvier 2005 (2005-01-01), pages S35-S44, XP009146900, ISSN: 0268-1242**

EP 2 598 455 B1

## Description

L'invention se rapporte au domaine des vitrages comprenant un substrat en verre, muni sur au moins une de ses faces d'un empilement de couches minces.

Pour des raisons environnementales et liées au souci d'économiser l'énergie, les habitations sont désormais munies de vitrages multiples, doubles, voire triples, souvent dotés de couches à propriétés de faible émissivité, destinées à limiter les transferts de chaleur vers l'extérieur de l'habitation. Ces vitrages à très faible coefficient de transmission thermique sont toutefois sujets à l'apparition de condensation d'eau sur leur surface extérieure, sous la forme de buée ou de givre. En cas de ciel dégagé durant la nuit, les échanges de chaleur par rayonnement avec le ciel entraînent une baisse de température qui n'est plus suffisamment compensée par les apports de chaleur provenant de l'intérieur de l'habitation. Lorsque la température de la surface extérieure du vitrage passe en dessous du point de rosée, l'eau condense sur ladite surface, gênant la visibilité au travers du vitrage le matin, parfois pendant plusieurs heures.

Afin de résoudre ce problème, il est connu de disposer en face 1 du vitrage (la face extérieure) une couche à propriété de basse émissivité, par exemple une couche d'un oxyde transparent électro-conducteur (TCO) afin de réduire les échanges radiatifs avec le ciel. La demande WO 2007/115796 préconise par exemple d'employer un empilement comprenant une couche TCO, une couche bloqueur et enfin une couche photocatalytique.

Une telle solution, si elle permet effectivement de résoudre en grande partie les problèmes de condensation d'eau, n'est toutefois pas dénuée d'inconvénients. Si l'épaisseur des couches n'est pas optimisée, cette solution réduit de manière importante le facteur solaire du vitrage. Le facteur solaire correspond à la fraction d'énergie solaire transmise par le vitrage vers l'intérieur de l'habitation, par transmission directe au travers du vitrage et par réémission du rayonnement absorbé par le vitrage vers l'intérieur. Or, il est important, surtout en hiver ou dans les pays de climat froid, de pouvoir maximiser les apports de chaleur solaire au travers du vitrage afin de réduire les dépenses de chauffage.

L'invention a pour but d'obvier à ces inconvénients en proposant un vitrage qui puisse limiter voire supprimer l'apparition de condensation (buée ou givre) sur la face externe, tout en pénalisant le moins possible le facteur solaire, et donc les transferts de chaleur vers l'intérieur de l'habitation.

A cet effet, l'invention a pour objet un vitrage comprenant un substrat en verre muni sur l'une de ses faces, destinée à former la face 1 dudit vitrage en position d'utilisation, d'un empilement de couches minces comprenant, depuis ledit substrat, une couche d'un oxyde transparent électro-conducteur, une couche intermédiaire d'indice de réfraction compris dans un domaine allant de 1,40 à 1,55 et d'épaisseur optique Y, et une couche photocatalytique dont l'épaisseur optique X est d'au plus 50 nm, lesdites épaisseurs optiques X et Y, exprimées en nanomètres, étant telles que :

$$110.e^{-0,025X} \leq Y \leq 135.e^{-0,018X} .$$

Par « face 1 » du vitrage, on entend, comme c'est l'usage dans la technique, la face externe du vitrage qui est destinée à être positionnée de manière à se trouver en contact avec l'extérieur de l'habitation. Les faces d'un vitrage sont numérotées en partant de l'extérieur, si bien que la face 2 est la face opposée à la face 1, autrement dit l'autre face de la même feuille de verre. Dans un vitrage multiple, comprenant deux feuilles de verre ou plus, la face 3 est la face de la deuxième feuille de verre du vitrage faisant face à la face 2, la face 4 est la face opposée à la face 3 etc.

Les indices de réfraction sont mesurés, par exemple par ellipsométrie, pour une longueur d'onde de 550 nm. L'épaisseur optique d'une couche correspond au produit de l'épaisseur physique (aussi appelée géométrique) de la couche et de son indice de réfraction.

Le vitrage selon l'invention est de préférence un vitrage multiple, notamment double ou triple, voire plus, par exemple quadruple. Ces vitrages ont en effet un faible coefficient de transmission thermique, et sont les plus affectés par le phénomène de condensation. Un vitrage double est généralement constitué de deux feuilles de verre se faisant face et ménageant une lame de gaz, par exemple d'air, d'argon, de xénon ou encore de krypton. On dispose généralement à la périphérie du vitrage, entre les feuilles de verre, un cadre espaceur, sous la forme d'un profilé métallique, par exemple en aluminium, solidarisé aux feuilles de verre par une colle, la périphérie du vitrage étant scellée à l'aide d'un mastic, par exemple en silicone, polysulfures ou polyuréthane, pour éviter toute entrée d'humidité au sein de la lame de gaz. Pour limiter l'humidité, on dispose fréquemment un tamis moléculaire dans le cadre espaceur. Un triple vitrage est constitué de la même manière, si ce n'est que le nombre de feuilles de verre est de trois.

Lorsque le vitrage selon l'invention est un vitrage triple, au moins une autre face, choisie parmi les faces 2 à 5, est de préférence revêtue d'un empilement à propriétés de faible émissivité. Il peut s'agir notamment d'empilements de couches minces comprenant au moins une couche d'argent, la ou chaque couche d'argent étant disposée entre des couches diélectriques. On entend par faible émissivité une émissivité généralement d'au plus 0,1, notamment 0,05. De préférence, deux autres faces, notamment les faces 2 et 5 sont revêtues d'un tel empilement. D'autres configurations sont également possibles, mais moins préférées : faces 2 et 3, 2 et 4, 3 et 4, 4 et 5, faces 2, 3 et 4, faces 2, 3 et 5, faces 2, 4 et 5, faces 2, 3, 4 et 5. D'autres types d'empilements peuvent être disposés sur les faces du vitrage, par exemple des empilements antireflets, en face 2, 3, 4, 5 ou 6.

Lorsque le vitrage selon l'invention est un vitrage double, la face 2 est avantageusement revêtue d'un empilement à propriétés de faible émissivité, notamment du type de celui qui vient d'être décrit. Alternativement, la face 2 peut être revêtue d'un empilement de contrôle solaire, ce qui n'est toutefois pas préféré car un tel empilement conduit à réduire le facteur solaire.

Le vitrage selon l'invention peut être employé comme tout type de vitrage. Il peut être intégré à une façade, une toiture, une véranda. Il peut être disposé à la verticale ou incliné.

Le substrat en verre est de préférence transparent et incolore (il s'agit alors d'un verre clair ou extra-clair). Il peut être coloré, par exemple en bleu, vert, gris ou bronze, mais ce mode de réalisation, pénalisant pour le facteur solaire, n'est pas préféré. Le verre est de préférence de type silico-sodo-calcique, mais il peut également être en verre de type borosilicate ou alumino-borosilicate. L'épaisseur du substrat est généralement comprise dans un domaine allant de 0,5 mm à 19 mm, de préférence de 0,7 à 9 mm, notamment de 2 à 8 mm, voire de 4 à 6 mm. Il en est de même, le cas échéant, pour les autres feuilles de verre du vitrage multiple.

Le substrat de verre est de préférence du type flotté, c'est-à-dire susceptible d'avoir été obtenu par un procédé consistant à déverser le verre fondu sur un bain d'étain en fusion (bain « float »). Dans ce cas, l'empilement peut aussi bien être déposé sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre.

Au moins une feuille de verre, dont celle munie de l'empilement qui constitue le coeur de l'invention, peut être trempée ou durcie, pour lui impartir des propriétés de résistance mécanique améliorée. Comme décrit par la suite, la trempe thermique peut également être utilisée pour améliorer les propriétés d'émissivité ou photocatalytiques des couches. Pour améliorer les propriétés acoustiques ou de résistance à l'effraction du vitrage selon l'invention, au moins une feuille de verre du vitrage peut être feuilletée à une autre feuille au moyen d'une feuille intercalaire en un polymère tel que le polyvinlybutyral (PVB) ou le polyuréthane (PU).

La couche d'un oxyde transparent électro-conducteur est de préférence une couche d'oxyde d'étain dopé au fluor ($SnO_2$ :F) ou une couche d'oxyde mixte d'étain et d'indium (ITO). D'autres couches sont possibles, parmi lesquelles les couches minces à base d'oxydes mixtes d'indium et de zinc (appelées « IZO »), à base d'oxyde de zinc dopé au gallium ou à l'aluminium, à base d'oxyde de titane dopé au niobium, à base de stannate de cadmium ou de zinc, à base d'oxyde d'étain dopé à l'antimoine. Dans le cas de l'oxyde de zinc dopé à l'aluminium, le taux de dopage (c'est-à-dire le poids d'oxyde d'aluminium rapporté au poids total) est de préférence inférieur à 3%. Dans le cas du gallium, le taux de dopage peut être plus élevé, typiquement compris dans un domaine allant de 5 à 6%. Dans le cas de l'ITO, le pourcentage atomique de Sn est de préférence compris dans un domaine allant de 5 à 70%, notamment de 10 à 60%. Pour les couches à base d'oxyde d'étain dopé au fluor, le pourcentage atomique de fluor est de préférence d'au plus 5%, généralement de 1 à 2%.

Ces couches présentent une bonne durabilité climatique, nécessaire lorsque l'empilement est disposé en face 1 du vitrage, ce qui n'est pas le cas d'autres couches bas-émissives, telles que les couches en argent. Ces dernières doivent impérativement être situées sur une face interne du vitrage multiple.

L'ITO est particulièrement préféré, notamment par rapport au $SnO_2$ :F. De conductivité électrique plus élevée, son épaisseur peut être plus faible pour obtenir un même niveau d'émissivité, ce qui permet de minimiser la perte de facteur solaire. Aisément déposées par un procédé de pulvérisation cathodique, notamment assisté par champ magnétique, appelé « procédé magnétron », ces couches se distinguent par une plus faible rugosité, et donc un plus faible encrassement. Lors de la fabrication, de la manutention et de l'entretien des vitrages, les couches plus rugueuses ont en effet tendance à piéger divers résidus, qui sont particulièrement difficiles à éliminer.

Un des avantages de l'oxyde d'étain dopé au fluor est en revanche sa facilité de dépôt par dépôt chimique en phase vapeur (CVD), qui contrairement au procédé de pulvérisation cathodique, ne nécessite pas de traitement thermique ultérieur, et peut être mis en oeuvre sur la ligne de production de verre plat par flottage.

L'épaisseur de la couche de TCO est ajustée, en fonction de la nature de la couche, de manière à obtenir l'émissivité voulue, laquelle dépend des performances anti-condensation recherchées. L'émissivité de la couche de TCO est de préférence inférieure ou égale à 0,4, notamment 0,3. Pour des couches en ITO, l'épaisseur géométrique sera généralement d'au moins 40 nm, voire 50 nm et même 70 nm, et souvent d'au plus 150 nm ou 200 nm. Pour des couches en oxyde d'étain dopé au fluor, l'épaisseur géométrique sera généralement d'au moins 120 nm, voire 200 nm, et souvent d'au plus 500 nm.

Lorsque le vitrage est destiné à être placé en position verticale, l'émissivité est de préférence d'au plus 0,4, voire 0,3. Dans le cas de l'oxyde d'étain dopé au fluor, cela nécessite généralement des épaisseurs géométriques d'au moins 120 nm, voire 200 nm. Dans le cas de l'ITO, l'épaisseur géométrique sera généralement d'au moins 40 nm, voire 50 nm, souvent d'au plus 150 nm.

Lorsque le vitrage est destiné à être placé en position inclinée, par exemple dans des applications en toiture, l'émissivité est de préférence d'au plus 0,3, voire 0,2 et même 0,18. Les épaisseurs géométriques d'oxyde d'étain dopé au fluor seront de préférence d'au moins 300 nm, et celles d'ITO d'au moins 60 nm, voire 70 ou 100 nm et souvent d'au plus 200 nm.

Par « émissivité », on entend l'émissivité normale à 283 K au sens de la norme EN 12898.

L'indice de réfraction de la couche d'oxyde transparent électro-conducteur est de préférence compris dans un domaine allant de 1,7 à 2,5.

Afin d'optimiser l'effet de l'invention, l'indice de réfraction de la couche intermédiaire est de préférence d'au plus 1,50, voire 1,48.

La couche intermédiaire est avantageusement à base de silice, voire constituée de silice. Il est entendu que la silice peut être dopée, ou ne pas être stoechiométrique. A titre d'exemples, la silice peut être dopée par les atomes d'aluminium ou de bore, dans le but de faciliter son dépôt par des procédés de pulvérisation cathodique. Dans le cas de dépôt chimique en phase vapeur (CVD), la silice peut être dopée par des atomes de bore ou de phosphore, qui accélèrent le dépôt. La silice peut encore être dopée par des atomes de carbone ou d'azote, en des teneurs suffisamment faibles pour que l'indice de réfraction de la couche reste dans les gammes susmentionnées. Une telle couche intermédiaire présente également l'avantage de protéger la couche de TCO, lui assurant une meilleure durabilité climatique ainsi qu'une meilleure résistance à la trempe. Dans le cas de TCO à base d'oxyde d'étain dopé au fluor, la couche intermédiaire présente en outre l'avantage de lisser la surface, diminuant l'abrasivité de la couche.

La couche photocatalytique est de préférence à base d'oxyde de titane, notamment une couche en oxyde de titane, en particulier dont l'indice de réfraction est compris dans un domaine allant de 2,0 à 2,5. L'oxyde de titane est de préférence au moins partiellement cristallisé sous la forme anatase, qui est la phase la plus active du point de vue de la photocatalyse. Des mélanges de phase anatase et rutile se sont aussi révélés très actifs. Le dioxyde de titane peut éventuellement être dopé par un ion métallique, par exemple un ion d'un métal de transition, ou par des atomes d'azote, de carbone, de fluor.... Le dioxyde de titane peut également être sous-stoechiométrique ou sur-stoechiométrique. Si l'oxyde de titane est nettement préféré, d'autres oxydes photocatalytiques peuvent aussi être employés, parmi lesquels $SrTiO_3$, ZnO, SiC, GaP, CdS, CdSe, $MoS_3$, $SnO_2$, ZnO, $WO_3$, $Fe_2O_3$, $Bi_2O_3$, $Nb_2O_5$, $KTaO_3$, $BiVO_4$, $Bi_2WO_6$.

Dans le vitrage selon l'invention, l'intégralité de la surface de la couche photocatalytique, notamment à base d'oxyde de titane, est de préférence en contact avec l'extérieur, de manière à pouvoir pleinement mettre en application sa fonction autonettoyante. Il peut toutefois être intéressant de revêtir la couche photocatalytique, notamment en dioxyde de titane, d'une fine couche hydrophile, notamment à base de silice afin d'améliorer dans le temps la persistance de l'hydrophilie.

L'épaisseur optique X de la couche photocatalytique, notamment à base d'oxyde de titane, est de préférence d'au plus 40 nm, notamment 30 nm. Son épaisseur géométrique est avantageusement d'au plus 20 nm, voire même 15 nm, ou encore 10 nm, et de préférence supérieure ou égale à 5 nm. De très fines couches, bien que moins actives photocatalytiquement parlant, présentent toutefois de bonnes propriétés auto-nettoyantes, antisalissures et antibuée. Même pour des couches de très faible épaisseur, l'oxyde de titane photocatalytique présente en effet la particularité, lorsqu'il est irradié par la lumière solaire, de devenir extrêmement hydrophile, avec des angles de contact à l'eau inférieurs à 5° et même 1°, ce qui permet à l'eau de ruisseler plus facilement, en éliminant les salissures déposées à la surface de la couche. En outre, les couches plus épaisses présentent une réflexion lumineuse plus élevée, ce qui a pour effet de diminuer le facteur solaire.

Selon un mode de réalisation possible, aucune couche n'est disposée entre la couche transparente électro-conductrice et la couche intermédiaire, et/ou entre la couche intermédiaire et la couche photocatalytique. Alternativement, une couche de protection peut être disposée entre la couche de TCO, notamment lorsqu'elle est en ITO, et la couche intermédiaire. Cette couche, dont l'épaisseur est avantageusement d'au plus 10 nm, notamment 5 nm, voire même 2 nm, permet de protéger le TCO, en particulier l'ITO, lors du dépôt de la couche intermédiaire, notamment lorsque le dépôt est effectué par pulvérisation cathodique, et lors d'éventuels traitements thermiques ultérieurs. L'indice de réfraction de la couche de protection est de préférence supérieur ou égal à celui de la couche de TCO. Le nitrure de silicium est particulièrement préféré.

On peut également disposer, entre le substrat et la couche d'un oxyde transparent électro-conducteur, une couche, ou un empilement de couches, de neutralisation. Dans le cas d'une couche unique, son indice de réfraction est de préférence compris entre l'indice de réfraction du substrat et l'indice de réfraction de ladite couche d'un oxyde transparent électro-conducteur. De telles couches ou empilements de couches permettent d'influer sur l'aspect en réflexion du vitrage, notamment sur sa couleur en réflexion. Des couleurs bleutées, caractérisées par des coordonnées colorimétriques b* négatives, sont préférées. A titre d'exemples non limitatifs, il est possible d'utiliser une couche d'oxyde mixte de silicium et d'étain ($SiSnO_x$), d'oxycarbure ou d'oxynitrure de silicium, d'oxyde d'aluminium, d'oxyde mixte de titane et de silicium. Un empilement de couches comprenant deux couches à haut et bas indice, par exemple un empilement $TiO_2/SiO_2$, $Si_3N_4/SiO_2$ ou $TCO/SiO_2$ est également utilisable (dans le dernier cas, le TCO peut être le même que celui déjà utilisé dans l'empilement, ou un autre TCO). L'épaisseur géométrique de cette ou de ces couches est de préférence comprise dans un domaine allant de 15 à 70 nm. Lorsque la couche d'un oxyde transparent électro-conducteur est en oxyde d'étain dopé au fluor, la sous-couche de neutralisation est de préférence en oxycarbure de silicium ou en oxyde mixte de silicium et d'étain. Lorsque la couche d'un oxyde transparent électro-conducteur est en ITO, on dispose de préférence sous cette couche une couche de neutralisation en un oxynitrure de silicium ou un empilement $Si_3N_4/SiO_2$.

En particulier lorsque la couche d'un oxyde transparent électro-conducteur est en ITO, il est préférable de disposer entre le substrat et la couche ou empilement de neutralisation une couche d'adhésion. Cette couche, qui présente avantageusement un indice de réfraction proche de celui du substrat de verre, permet d'améliorer la tenue à la trempe en favorisant l'accrochage de la couche de neutralisation. La couche d'adhésion est de préférence en silice. Son épaisseur géométrique est de préférence comprise dans un domaine allant de 20 à 200 nm, notamment de 30 à 150 nm.

Les différents modes de réalisation préférés décrits ci-avant peuvent bien entendu être combinés entre eux. Toutes les combinaisons possibles ne sont bien entendu pas explicitement décrites dans le présent texte. Quelques exemples d'empilements particulièrement préférés sont donnés ci-après.

1. Verre / SiOC / $SnO_2$ : F / $SiO_2$ / $TiO_2$

2. Verre / $SiSnO_x$ / $SnO_2$ : F/ $SiO_2$ / $TiO_2$

3. Verre / ($SiO_2$) / $SiO_xN_y$ / ITO / $Si_3N_4$ / $SiO_2$ / $TiO_2$

4. Verre / $SiO_2$ / $Si_3N_4$ / $SiO_2$ / ITO / $Si_3N_4$ / $SiO_2$ / $TiO_2$

5. Verre / $Si_3N_4$ / $SiO_2$ / ITO / $Si_3N_4$ / $SiO_2$ / $TiO_2$

Dans ces empilements, l'épaisseur géométrique de la couche de $TiO_2$ est avantageusement d'au plus 15 nm, voire 10 nm. L'épaisseur de la couche de TCO est à choisir de manière indépendante, en fonction de l'émissivité voulue, comme expliqué plus avant dans la présente description.

Les empilements 1 et 2 utilisent une couche TCO en oxyde d'étain dopé au fluor. Ces empilements sont de préférence obtenus par dépôt chimique en phase vapeur, généralement directement sur la ligne de flottage du verre.

Les empilements 3 à 5, qui utilisent l'ITO, sont de préférence obtenus par pulvérisation cathodique magnétron. Les exemples 3 et 4 contiennent sur le verre une couche d'adhésion en silice (optionnelle pour l'exemple 3), puis une couche de neutralisation en oxynitrure de silicium ou un empilement de neutralisation constitué d'une couche de nitrure de silicium surmontée par une couche de silice, la couche de TCO, une couche de protection en nitrure de silicium, une couche intermédiaire en silice et enfin la couche photocatalytique en dioxyde de titane. L'exemple 5 correspond à l'exemple 4, mais sans la couche d'adhésion en silice. Les formules données ne préjugent pas de la stoechiométrie réelle des couches, et d'un éventuel dopage.

Le vitrage selon l'invention est de préférence obtenu par un procédé en plusieurs étapes. Les couches de l'empilement sont déposées sur le substrat de verre, qui se présente alors généralement sous la forme d'une grande feuille de verre de $3,2*6m^2$, ou directement sur le ruban de verre pendant ou juste après le processus de flottage, puis le substrat est découpé aux dimensions finales du vitrage. Après façonnage des bords, on fabrique ensuite le vitrage multiple en associant le substrat à d'autres feuilles de verre, elles-mêmes éventuellement munies au préalable de revêtements fonctionnels, par exemple du type bas-émissif.

Les différentes couches de l'empilement peuvent être déposées sur le substrat en verre par tout type de procédé de dépôt de couche mince. Il peut par exemple s'agir de procédés de type sol-gel, pyrolyse (liquide ou solide), dépôt chimique en phase vapeur (CVD), notamment assisté par plasma (APCVD), éventuellement sous pression atmosphérique (APPECVD), évaporation.

Selon un mode de réalisation préféré, les couches de l'empilement sont obtenues par dépôt chimique en phase vapeur, directement sur la ligne de production de la feuille de verre par flottage. C'est de préférence le cas lorsque la couche de TCO est une couche d'oxyde d'étain dopé au fluor. Le dépôt est réalisé par pulvérisation de précurseurs au travers de buses, sur le ruban de verre chaud. Le dépôt des différentes couches peut se faire à différents endroits de la ligne : dans l'enceinte de flottage, entre l'enceinte de flottage et l'étenderie, ou dans l'étenderie. Les précurseurs sont généralement des molécules organométalliques ou du type halogénures. A titre d'exemples, on peut citer pour l'oxyde d'étain dopé au fluor le tétrachlorure d'étain, le trichlorure de monobutyl étain (MTBCL), l'acide trifluoroacétique, l'acide fluorhydrique. L'oxyde de silicium peut être obtenu à l'aide de silane, de tétraéthoxysilane (TEOS), ou encore d'hexamethyldisiloxane (HDMSO), en utilisant éventuellement un accélérateur tel que le triethylphosphate. L'oxyde de titane peut être obtenu à partir de tétrachlorure de titane ou d'isopropoxide de titane. Le procédé CVD, qui met en oeuvre un dépôt sur verre chaud, présente l'avantage d'obtenir directement une couche de TCO et une couche photocatalytique bien cristallisées.

Selon un autre mode de réalisation préféré, les couches de l'empilement sont obtenues par pulvérisation cathodique, notamment assistée par un champ magnétique (procédé magnétron). C'est de préférence le cas lorsque la couche de TCO est une couche d'ITO. Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée. Ce procédé est dit « réactif » lorsque la couche est constituée d'un matériau résultant d'une réaction chimique entre les éléments arrachés de la cible et le gaz contenu dans le plasma. L'avantage majeur de ce procédé réside dans la possibilité de déposer sur une même ligne un empilement très complexe de couches en faisant successivement défiler le substrat sous différentes cibles, ce généralement dans un seul et même dispositif.

Le procédé magnétron présente toutefois un inconvénient lorsque le substrat n'est pas chauffé lors du dépôt : les couches de TCO et d'oxyde de titane obtenues sont faiblement cristallisées si bien que leurs propriétés respectives d'émissivité et d'activité photocatalytiques ne sont pas optimisées. Un traitement thermique se révèle alors nécessaire.

Ce traitement thermique, destiné à améliorer la cristallisation des couches de TCO et photocatalytique, est de préférence choisi parmi les traitements de trempe, de recuit, de recuit rapide. L'amélioration de la cristallisation peut être quantifiée par une augmentation du taux de cristallisation (la proportion massique ou volumique de matière cristallisée) et/ou de la taille des grains cristallins (ou la taille de domaines cohérents de diffraction mesurés par des méthodes de diffraction des rayons X ou de spectroscopie Raman). Cette amélioration de la cristallisation peut aussi être vérifiée de manière indirecte, par l'amélioration des propriétés de la couche. Dans le cas d'une couche de type TCO, l'émissivité diminue, de préférence d'au moins 5% en relatif, voire d'au moins 10% ou 15%, de même que son absorption lumineuse et énergétique. Dans le cas de couches en dioxyde de titane, l'amélioration de la cristallisation se traduit par une augmentation de l'activité photocatalytique. L'activité est généralement évaluée en suivant la dégradation de polluants modèles, tels que l'acide stéarique ou le bleu de méthylène.

Le traitement de trempe ou de recuit est généralement mis en oeuvre dans un four, respectivement de trempe ou de recuisson. L'intégralité du substrat, est portée à une température élevée, d'au moins 300°C dans le cas de la recuisson, et d'au moins 500°C, voire 600°C, dans le cas d'une trempe.

Le recuit rapide est de préférence mis en oeuvre à l'aide d'une flamme, d'une torche plasma ou d'un rayonnement laser. Dans ce type de procédé, on vient créer un mouvement relatif entre le substrat et le dispositif (flamme, laser, torche plasma). Généralement, le dispositif est mobile, et le substrat revêtu vient défiler au regard du dispositif de manière à traiter sa surface. Ces procédés permettent d'apporter une grande densité d'énergie au revêtement à traiter en un temps très faible, limitant ainsi la diffusion de la chaleur vers le substrat, et donc le chauffage dudit substrat. La température du substrat est généralement d'au plus 100°C, voire 50° et même 30°C pendant le traitement. Chaque point de la couche mince est soumis au traitement de recuit rapide pendant une durée généralement inférieure ou égale à 1 seconde, voire 0,5 seconde.

Le traitement thermique de recuit rapide est de préférence mis en oeuvre à l'aide d'un rayonnement laser émettant dans l'infrarouge ou le visible. La longueur d'onde du rayonnement est de préférence comprise dans un domaine allant de 530 à 1200 nm, ou de 600 à 1000 nm, notamment de 700 à 1000 nm, voire de 800 à 1000 nm. On utilise de préférence des diodes laser, émettant par exemple à une longueur d'onde de l'ordre de 808 nm, 880 nm, 915 ou encore 940 nm ou 980 nm. Sous forme de systèmes de diodes, de très fortes puissances peuvent être obtenues, permettant d'atteindre des puissances surfaciques au niveau du revêtement à traiter supérieures à 20kW/cm$^2$, voire à 30kW/cm$^2$.

Le rayonnement laser est de préférence issu d'au moins un faisceau laser formant une ligne (appelée « ligne laser » dans la suite du texte) qui irradie simultanément toute ou partie de la largeur du substrat. Ce mode est préféré car il évite l'utilisation de systèmes de déplacement coûteux, généralement encombrants, et d'entretien délicat. Le faisceau laser en ligne peut notamment être obtenu à l'aide de systèmes de diodes laser de forte puissance associées à une optique de focalisation. L'épaisseur de la ligne est de préférence comprise entre 0,01 et 1 mm. La longueur de la ligne est typiquement comprise entre 5 mm et 1 m. Le profil de la ligne peut notamment être une courbe de Gauss ou un créneau. La ligne laser irradiant simultanément toute ou partie de la largeur du substrat peut être composée d'une seule ligne (irradiant alors toute la largeur du substrat), ou de plusieurs lignes, éventuellement disjointes. Lorsque plusieurs lignes sont utilisées, il est préférable qu'elles soient disposées de sorte que toute la surface de l'empilement soit traitée. La ou chaque ligne est de préférence disposée perpendiculairement à la direction de défilement du substrat, ou disposée de manière oblique. Les différentes lignes peuvent traiter le substrat simultanément, ou de manière décalée dans le temps. L'important est que toute la surface à traiter le soit. Le substrat peut ainsi être mis en déplacement, notamment en défilement en translation en regard de la ligne laser fixe, généralement en dessous, mais éventuellement au-dessus de la ligne laser. Ce mode de réalisation est particulièrement appréciable pour un traitement en continu. Alternativement, le substrat peut être fixe et le laser peut être mobile. De préférence, la différence entre les vitesses respectives du substrat et du laser est supérieure ou égale à 1 mètre par minute, voire 4 et même 6, 8, 10 ou 15 mètres par minute, ce afin d'assurer une grande vitesse de traitement. Lorsque le substrat est en déplacement, notamment en translation, il peut être mis en mouvement à l'aide de tous moyens mécaniques de convoyage, par exemple à l'aide de bandes, de rouleaux, de plateaux en translation. Le système de convoyage permet de contrôler et réguler la vitesse du déplacement. Le laser peut également être mis en mouvement de manière à ajuster sa distance au substrat, ce qui peut être utile en particulier lorsque le substrat est bombé, mais pas seulement. En effet, il est préférable que le faisceau laser soit focalisé sur le revêtement à traiter de sorte que ce dernier soit situé à une distance inférieure ou égale à 1 mm du plan focal. Si le système de déplacement du substrat ou du laser n'est pas suffisamment précis quant à la distance entre le substrat et le plan focal, il convient de préférence de pouvoir ajuster la distance entre le laser et le substrat. Cet ajustement peut être automatique, notamment régulé grâce à une mesure de la distance en amont du traitement.

Le dispositif de rayonnement laser peut être intégré dans une ligne de dépôt de couches, par exemple une ligne de dépôt par pulvérisation cathodique assistée par champ magnétique (procédé magnétron), ou une ligne de dépôt chimique en phase vapeur (CVD), notamment assistée par plasma (PECVD), sous vide ou sous pression atmosphérique (APPECVD).

L'invention a aussi pour objet l'utilisation du vitrage selon l'invention pour réduire l'apparition de condensation d'eau (notamment buée ou givre) sur la surface dudit vitrage.

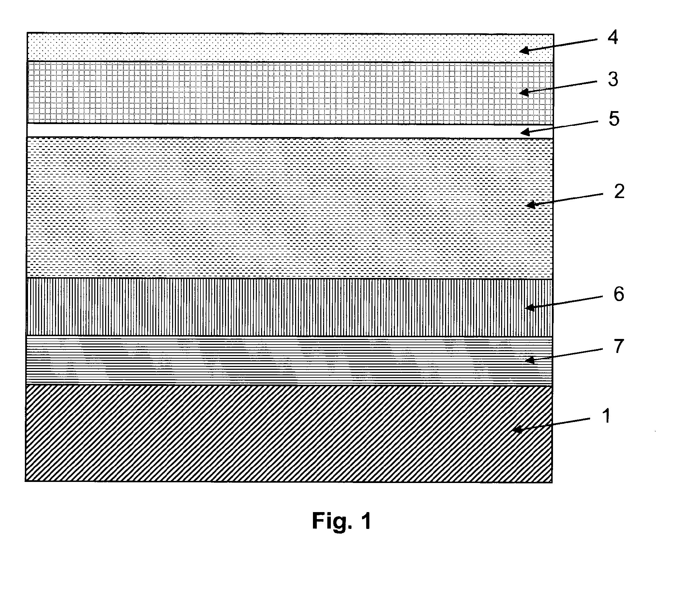

La Figure 1 illustre de manière schématique une coupe d'une partie du vitrage selon l'invention. Seul l'empilement disposé en face 1 du vitrage et une partie du substrat de verre sont représentés.

Sont représentées, déposées sur le substrat 1 (typiquement en verre), la couche 2 d'un oxyde transparent électro-conducteur (typiquement en ITO), la couche intermédiaire 3 (typiquement en SiO$_2$) et la couche photocatalytique 4 (typiquement en TiO$_2$). Les couches optionnelles sont la couche de protection 5 (typiquement en Si$_3$N$_4$), la couche ou l'empilement de neutralisation 6 (typiquement un empilement Si$_3$N$_4$/SiO$_2$) et la couche d'adhésion 7 (par exemple en SiO$_2$).

Les exemples qui suivent illustrent l'invention sans toutefois la limiter.

EXEMPLE 1

Cet exemple illustre un mode de réalisation dans lequel les couches sont déposées par CVD (dépôt chimique en phase vapeur), le TCO étant l'oxyde d'étain dopé au fluor (SnO$_2$ :F).

On dépose de manière connue sur un substrat de verre des empilements constitués, en partant du substrat, d'une couche de neutralisation en oxycarbure de silicium (de formule générique SiOC), d'indice de réfraction 1,65, d'une couche de TCO en oxyde d'étain dopé au fluor, d'indice de réfraction 1,8, d'une couche intermédiaire en silice, d'indice 1,48, et enfin d'une couche photocatalytique en TiO$_2$, d'indice 2,0. Comme dans tout le texte, les indices de réfraction sont donnés pour une longueur d'onde de 550 nm.

Le substrat employé dans le cadre de l'exemple est une feuille de verre clair de 4 mm d'épaisseur, commercialisé sous la marque SGG Planilux® par la demanderesse.

Le tableau 1 ci-après indique, pour chaque échantillon, selon l'invention ou comparatif :
- les épaisseurs géométriques (en nm) de chacune des couches de l'empilement,
- la transmission énergétique du substrat revêtu de l'empilement (ou facteur de transmission directe de l'énergie solaire), notée TE, au sens de la norme EN 410 :1998,
- les coordonnées colorimétriques a*, b*, en réflexion côté empilement, calculées en prenant comme référence l'illuminant D65 et l'observateur de référence CIE-1931.

Tableau 1

|  | C1 | C2 | 1 | 2 |
|---|---|---|---|---|
| TiO$_2$ (nm) | 15 | 15 | 15 | 15 |
| SiO$_2$ (nm) | 20 | 80 | 50 | 50 |
| SnO$_2$ : F (nm) | 300 | 300 | 300 | 300 |
| SiOC (nm) | 45 | 45 | 45 | 0 |
|  |  |  |  |  |
| TE (%) | 71,5 | 71,9 | 72,8 | 72,5 |
| a* |  |  | -0,5 | -11,2 |
| b* |  |  | -0, 9 | 4,4 |

Les exemples comparatifs C1 et C2 possèdent une couche intermédiaire dont l'épaisseur n'est pas optimisée, au contraire des exemples 1 et 2 selon l'invention.

Cela se traduit, pour les exemples selon l'invention, par un gain de transmission énergétique, de plus de 0,5%, voire 1%.

La comparaison entre les exemples 1 et 2 illustre l'effet de la couche de neutralisation en SiOC : l'empilement de l'exemple 2, qui en est dépourvu, présente un aspect moins neutre en réflexion, tirant sur le jaune-vert.

On réalise à partir des substrats C1, C2 et 1 un triple vitrage. L'empilement photocatalytique est disposé en face 1 du vitrage, tandis que deux empilements bas-émissifs à base d'argent sont respectivement disposés en face 2 et 5.

Le tableau 2 ci-après indique dans chaque cas :

- la transmission énergétique du vitrage (ou facteur de transmission directe de l'énergie solaire), notée TE,

- le facteur solaire du vitrage, noté g.

Ces deux grandeurs sont calculées au sens de la norme EN 410 :1998.

Tableau 2

|  | C1 | C2 | 1 |
|---|---|---|---|
| TE (%) | 44, 9 | 45,3 | 45,8 |
| g (%) | 52,1 | 52,5 | 53,1 |

Le choix de l'épaisseur de la couche intermédiaire permet donc d'obtenir un gain très significatif en facteur solaire.

EXEMPLE 2

Cet exemple illustre un mode de réalisation dans lequel les couches sont déposées par pulvérisation cathodique (procédé magnétron), le TCO étant l'ITO (oxyde mixte d'étain et d'indium).

On dépose de manière connue sur un substrat de verre des empilements constitués, en partant du substrat, d'un empilement de neutralisation constitué d'une couche en nitrure de silicium ($Si_3N_4$) d'indice de réfraction égal à 2,0 puis d'une couche en silice d'indice de réfraction égal à 1,48, d'une couche de TCO en oxyde mixte d'étain et d'indium (ITO) d'indice de réfraction 1,8, d'une couche intermédiaire en silice ($SiO_2$) d'indice de réfraction de 1,48 et enfin d'une couche photocatalytique en $TiO_2$ dont l'indice de réfraction est de 2,5. Le substrat revêtu de son empilement subit une étape de recuit après le dépôt des couches. Le substrat est le même que celui utilisé dans les exemples précédents.

Le tableau 3 ci-après indique, pour chaque échantillon, selon l'invention ou comparatif :

- les épaisseurs géométriques (en nm) de chacune des couches de l'empilement,

- la transmission énergétique (ou facteur de transmission directe de l'énergie solaire), notée TE, au sens de la norme EN 410 :1998, du substrat revêtu de l'empilement,

- les coordonnées colorimétriques a*, b*, en réflexion côté empilement, calculées en prenant comme référence l'illuminant D65 et l'observateur de référence CIE-1931.

Tableau 3

|  | C3 | C4 | 3 | 4 |
|---|---|---|---|---|
| $TiO_2$ (nm) | 12 | 12 | 12 | 12 |
| $SiO_2$ (nm) | 10 | 70 | 40 | 40 |
| ITO (nm) | 100 | 100 | 100 | 100 |
| $SiO_2$ (nm) | 11 | 11 | 11 | 0 |
| $Si_3N_4$ (nm) | 16,5 | 16,5 | 16,5 | 0 |
|  |  |  |  |  |
| TE (%) | 76,3 | 76,2 | 77, 9 | 77,4 |
| a* |  |  | -4,4 | 10, 6 |
| b* |  |  | -9, 6 | -20, 6 |

Les exemples comparatifs C3 et C4 possèdent une couche intermédiaire dont l'épaisseur n'est pas optimisée, au contraire des exemples 3 et 4 selon l'invention.

Cela se traduit, pour les exemples selon l'invention, par un gain de transmission énergétique d'au moins 1%.

La comparaison entre les exemples 3 et 4 illustre l'effet de l'empilement de neutralisation $Si_3N_4/SiO_2$ : l'empilement de l'exemple 4, qui en est dépourvu, présente un aspect moins neutre en réflexion, tirant sur le violet.

On réalise à partir des substrats C3, C4 et 3 un triple vitrage. L'empilement photocatalytique est disposé en face 1 du vitrage, tandis que deux empilements bas-émissifs à base d'argent sont respectivement disposés en face 2 et 5.

Le tableau 4 ci-après indique dans chaque cas :

- la transmission énergétique du vitrage (ou facteur de transmission directe de l'énergie solaire), notée TE,

- le facteur solaire du vitrage, noté g.

Ces deux grandeurs sont calculées au sens de la norme EN 410 :1998.

Tableau 4

|  | C3 | C4 | 3 |
|---|---|---|---|
| TE (%) | 47,3 | 47,2 | 48,2 |
| g (%) | 56,0 | 55,8 | 57,0 |

Le choix de l'épaisseur de couche intermédiaire effectué selon l'invention permet donc d'obtenir un gain très significatif en facteur solaire, d'au moins 1% en valeur absolue. L'utilisation d'ITO permet en outre d'augmenter le facteur solaire par rapport à l'oxyde d'étain dopé au fluor, pour un niveau d'émissivité (et donc anti-condensation) comparable.

Une très fine couche de protection en nitrure de silicium peut être disposée entre la couche de TCO et la couche intermédiaire, sans effets significatifs sur les propriétés optiques et énergétiques du vitrage.

Les différents vitrages exemplifiés permettent de réduire très fortement l'apparition de condensation d'eau, telle que buée ou givre.

**Revendications**

1. Vitrage comprenant un substrat en verre (1) muni sur l'une de ses faces, destinée à former la face 1 dudit vitrage en position d'utilisation, d'un empilement de couches minces comprenant, depuis ledit substrat (1), une couche (2) d'un oxyde transparent électro-conducteur, une couche intermédiaire (3) d'indice de réfraction compris dans un domaine allant de 1,40 à 1,55 et d'épaisseur optique Y, et une couche photocatalytique (4) dont l'épaisseur optique X est d'au plus 50 nm, lesdites épaisseurs optiques X et Y, exprimées en nanomètres, étant telles que :

$$110.e^{-0,025X} \le Y \le 135.e^{-0,018X}.$$

2.  Vitrage selon la revendication 1, qui est un vitrage multiple, notamment double ou triple.

3.  Vitrage selon l'une des revendications précédentes, tel que la couche (2) d'un oxyde transparent électro-conducteur est une couche d'oxyde d'étain dopé au fluor ou une couche d'oxyde mixte d'étain et d'indium.

4.  Vitrage selon l'une des revendications précédentes, tel que l'indice de réfraction de la couche (2) d'un oxyde transparent électro-conducteur est compris dans un domaine allant de 1,7 à 2,5.

5.  Vitrage selon l'une des revendications précédentes, tel que l'émissivité de la couche (2) d'un oxyde transparent électro-conducteur est inférieure ou égale à 0,4, notamment 0,3.

6.  Vitrage selon l'une des revendications précédentes, tel que la couche intermédiaire (3) est à base de silice.

7.  Vitrage selon l'une des revendications précédentes, tel que la couche photocatalytique (4) est à base d'oxyde de titane

8.  Vitrage selon la revendication précédente, telle que la couche photocatalytique (4) est une couche en oxyde de titane, dont l'indice de réfraction est compris dans un domaine allant de 2,0 à 2,5.

9.  Vitrage selon l'une des revendications précédentes, tel que l'épaisseur optique X est d'au plus 40 nm, notamment 30 nm.

10. Vitrage selon l'une des revendications précédentes, dans lequel une couche de protection (5) est disposée entre la couche (2) d'un oxyde transparent électro-conducteur, notamment en oxyde mixte d'étain et d'indium, et la couche intermédiaire (3).

11. Vitrage selon l'une des revendications précédentes, dans lequel on dispose, entre le substrat (1) et la couche (2) d'un oxyde transparent électro-conducteur, une couche, ou un empilement de couches, de neutralisation (6).

12. Vitrage selon la revendication précédente, dans lequel la couche (2) d'un oxyde transparent électro-conducteur est une couche d'un oxyde mixte d'étain et d'indium, et l'on dispose entre le substrat (1) et la couche ou empilement de neutralisation (6) une couche d'adhésion (7).

13. Vitrage selon l'une des revendications précédentes, tel que l'empilement positionné en face 1 est choisi parmi les empilements suivantes :

    • Verre / SiOC / SnO$_2$: F / SiO$_2$ / TiO$_2$
    • Verre / SiSnO$_x$ / SnO$_2$: F/ SiO$_2$ / TiO$_2$
    • Verre / SiO$_2$ / SiO$_x$N$_y$ / ITO / Si$_3$N$_4$ / SiO$_2$ / TiO$_2$
    • Verre / SiO$_2$ / Si$_3$N$_4$ / SiO$_2$ / ITO / Si$_3$N$_4$ / SiO$_2$ / TiO$_2$
    • Verre / Si$_3$N$_4$ / SiO$_2$ / ITO / Si$_3$N$_4$ / SiO$_2$ / TiO$_2$

14. Vitrage selon l'une des revendications précédentes, qui est un vitrage triple dans lequel au moins une autre face, choisie parmi les faces 2 à 5, est revêtue d'un empilement à propriétés de faible émissivité, notamment les faces 2 et 5.

15. Procédé d'obtention d'un vitrage selon l'une des revendications précédentes, dans lequel les couches sont déposées par pulvérisation cathodique, puis subissent un traitement thermique destiné à améliorer la cristallisation des couches de TCO et photocatalytique, ledit traitement thermique étant choisi parmi les traitements de trempe, de recuit, de recuit rapide.

16. Procédé selon la revendication précédente, tel que le recuit rapide est mis en oeuvre à l'aide d'une flamme, d'une torche plasma ou d'un rayonnement laser.

17. Utilisation du vitrage selon l'une des revendications de vitrage précédentes pour réduire l'apparition de condensation d'eau sur la surface dudit vitrage.

**Patentansprüche**

1.  Verglasung, umfassend ein Glassubstrat (1), das auf einer seiner Flächen, die dazu bestimmt ist, in der Verwendungsposition der Verglasung die Fläche 1 zu bilden, mit einer Aufschichtung dünner Schichten versehen ist, die, ausgehend von dem Substrat (1), eine Schicht (2) aus einem transparenten elektrisch leitfähigen Oxid, eine Zwischenschicht (3) mit einem Brechungsindex innerhalb eines Bereichs von 1,40 bis 1,55 und einer optischen Dicke Y und eine photokatalytische Schicht (4), deren optische Dicke X höchstens 50 nm beträgt, umfasst, wobei die optischen Dicken X und Y, ausgedrückt in Nanometern, folgendermaßen gewählt sind:

$$110.e^{-0,025X} \le Y \le 135.e^{-0,018X}.$$

2.  Verglasung nach Anspruch 1, wobei die Verglasung eine Mehrfachverglasung, insbesondere eine Zweifach- oder Dreifachverglasung ist.

3. Verglasung nach einem der vorhergehenden Ansprüche, wobei die Schicht (2) aus einem transparenten elektrisch leitfähigen Oxid eine Schicht aus Fluordotiertem Zinnoxid oder eine Schicht aus einem Mischoxid aus Zinn und Indium ist.

4. Verglasung nach einem der vorhergehenden Ansprüche, wobei der Brechungsindex der Schicht (2) aus einem transparenten elektrisch leitfähigen Oxid innerhalb eines Bereichs von 1,7 bis 2,5 liegt.

5. Verglasung nach einem der vorhergehenden Ansprüche, wobei derEmissionsgrad der Schicht (2) aus einem transparenten elektrisch leitfähigen Oxid kleiner oder gleich 0,4, insbesondere 0,3 ist.

6. Verglasung nach einem der vorhergehenden Ansprüche, wobei die Zwischenschicht (3) auf Siliziumdioxid basiert.

7. Verglasung nach einem der vorhergehenden Ansprüche, wobei die photokatalytische Schicht (4) auf Titanoxid basiert.

8. Verglasung nach dem vorhergehenden Anspruch, wobei die photokatalytische Schicht (4) eine Titanoxidschicht ist, deren Brechungsindex innerhalb eines Bereichs von 2,0 bis 2,5 liegt.

9. Verglasung nach einem der vorhergehenden Ansprüche, wobei die optische Dicke X höchstens 40 nm, insbesondere 30 nm beträgt.

10. Verglasung nach einem der vorhergehenden Ansprüche, wobei eine Schutzschicht (5) zwischen der Schicht (2) aus einem transparenten elektrisch leitfähigen Oxid, insbesondere einem Mischoxid aus Zinn und Indium, und der Zwischenschicht (3) angeordnet ist.

11. Verglasung nach einem der vorhergehenden Ansprüche, wobei zwischen dem Substrat (1) und der Schicht (2) aus einem transparenten elektrisch leitfähigen Oxid eine Neutralisierungsschicht oder eine Aufschichtung von Neutralisierungsschichten (6) angeordnet wird.

12. Verglasung nach dem vorhergehenden Anspruch, wobei die Schicht (2) aus einem transparenten elektrisch leitfähigen Oxid eine Schicht aus einem Mischoxid aus Zinn und Indium ist, und zwischen dem Substrat (1) und der Neutralisierungsschicht oder der Aufschichtung von Neutralisierungsschichten (6) eine Adhäsionsschicht (7) angeordnet wird.

13. Verglasung nach einem der vorhergehenden Ansprüche, wobei die an Fläche 1 positionierte Aufschichtung aus der folgenden Gruppe von Aufschichtungen ausgewählt ist:

- Glas / SiOC / $SnO_2$:F / $SiO_2$ /$TiO_2$
- Glas / SiSnOX / $SnO_2$:F / $SiO_2$ / $TiO_2$
- Glas / $SiO_2$ / $SiO_xNy$ / ITO / $Si_3N_4$ / $SiO_2$ /$TiO_2$
- Glas / $SiO_2$ / $Si_3N_4$ / $SiO_2$ / ITO / $Si_3N_4$ / $SiO_2$ / $TiO_2$
- Glas / $Si_3N_4$/ $SiO_2$ / ITO / $Si_3N_4$ / $SiO_2$ / $TiO_2$

14. Verglasung nach einem der vorhergehenden Ansprüche, wobei die Verglasung eine Dreifachverglasung ist, wobei mindestens eine andere Fläche, ausgewählt aus den Flächen 2 bis 5, von einer Aufschichtung mit der Eigenschaft eines schwachen Emissionsgrads beschichtet ist, insbesondere die Schichten 2 und 5.

15. Verfahren zum Erhalten einer Verglasung nach einem der vorhergehenden Ansprüche, wobei die Schichten durch Kathodenzerstäubung abgelagert werden, dann eine Wärmebehandlung durchlaufen, die dazu bestimmt ist, die Kristallisation der TCO-Schicht und der photokatalytischen Schicht zu verbessern, wobei die Wärmebehandlung aus der Gruppe bestehend aus Härten, Anlassen und schnelles Anlassen ausgewählt ist.

16. Verfahren nach dem vorhergehenden Anspruch, wobei das schnelle thermische Anlassen mit Hilfe einer Flamme, eines Plasmabrenners oder Laserstrahlung erfolgt.

17. Verwendung der Verglasung nach einem der vorhergehenden Ansprüche der Verglasung zum Verringern des Auftretens von Wasserkondensation auf der Oberfläche der Verglasung.

**Claims**

1. A glazing unit comprising a glass substrate (1) equipped on one of its faces, intended to form face 1 of said glazing unit in the use position, with a thin-film multilayer comprising, from said substrate (1), a film (2) of a transparent electrically conductive oxide, an intermediate film (3) having a refractive index lying in the range from 1.40 to 1.55 and having an optical thickness Y, and a photocatalytic film (4) the optical thickness X of which is at most 50 nm, said optical thicknesses X and Y, expressed in nanometers, being such that:

$$110 \cdot e^{-0.025X} \leq Y \leq 135 \cdot e^{-0.018X} \ .$$

**2.** The glazing unit as claimed in claim 1, which is a multiple glazing unit, especially a double or triple glazing unit.

**3.** The glazing unit as claimed in either one of the preceding claims, such that the film (2) of a transparent electrically conductive oxide is a film of fluorine-doped tin oxide or a film of mixed indium tin oxide.

**4.** The glazing unit as claimed in one of the preceding claims, such that the refractive index of the film (2) of a transparent electrically conductive oxide lies in the range from 1.7 to 2.5.

**5.** The glazing unit as claimed in one of the preceding claims, such that the emissivity of the film (2) of a transparent electrically conductive oxide is less than or equal to 0.4, especially 0.3.

**6.** The glazing unit as claimed in one of the preceding claims, such that the intermediate film (3) is based on silica.

**7.** The glazing unit as claimed in one of the preceding claims, such that the photocatalytic film (4) is based on titanium oxide.

**8.** The glazing unit as claimed in the preceding claim, such that the photocatalytic film (4) is a film of titanium oxide the refractive index of which lies in the range from 2.0 to 2.5.

**9.** The glazing unit as claimed in one of the preceding claims, such that the optical thickness X is at most 40 nm, especially 30 nm.

**10.** The glazing unit as claimed in one of the preceding claims, in which a protective film (5) is placed between the film (2) of a transparent electrically conductive oxide, especially a mixed indium tin oxide, and the intermediate film (3).

**11.** The glazing unit as claimed in one of the preceding claims, in which a neutralizing film or a neutralizing multilayer of films (6) is placed between the substrate (1) and the film (2) of a transparent electrically conductive oxide.

**12.** The glazing unit as claimed in the preceding claim, in which the film (2) of a transparent electrically conductive oxide is a film of a mixed indium tin oxide, and an adhesive film (7) is placed between the substrate (1) and the neutralizing film or multilayer (6).

**13.** The glazing unit as claimed in one of the preceding claims, such that the multilayer positioned on face 1 is chosen from the following multilayers:

- glass/SiOC/SnO$_2$ : F/SiO$_2$/TiO$_2$
- glass/SiSnO$_x$/SnO$_2$: F/SiO$_2$/TiO$_2$
- glass/SiO$_2$/SiO$_x$N$_y$/ITO/Si$_3$N$_4$/SiO$_2$/TiO$_2$
- glass/SiO$_2$/Si$_3$N$_4$/SiO$_2$/ITO/Si$_3$N$_4$/SiO$_2$/TiO$_2$
- glass/Si$_3$N$_4$/SiO$_2$/ITO/Si$_3$N$_4$/SiO$_2$/TiO$_2$.

**14.** The glazing unit asclaimed in one of the preceding claims, which is a triple glazing unit in which at least one other face, chosen from faces 2 to 5, is coated with a multilayer having low-E properties, especially faces 2 and 5.

**15.** A method for obtaining a glazing unit as claimed in one of the preceding claims, in which the films are deposited by sputtering, then undergo a heat treatment intended to improve the crystallization of the TCO film and the photocatalytic film, said heat treatment being chosen from tempering, annealing or rapid-annealing treatments.

**16.** The method as claimed in the preceding claim, such that the rapid annealing is implemented using a flame, a plasma torch or a laser.

**17.** The use of the glazing unit as claimed in one of the preceding glazing-unit claims to reduce the appearance of condensated water on the surface of said glazing unit.

**Fig. 1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2007115796 A